Europäisches Patentamt

(19) European Patent Office

Office européen des brevets

(11) Veröffentlichungsnummer: **0 173 642 B1**

## (12) EUROPÄISCHE PATENTSCHRIFT

(45) Veröffentlichungstag der Patentschrift: **23.01.91**

(21) Anmeldenummer: **85730102.2**

(22) Anmeldetag: **25.07.85**

(51) Int. Cl.⁵: **C 30 B 25/00, C 30 B 25/02, C 30 B 29/46**

(54) **Photoaktive Pyritschicht, Verfahren zu deren Herstellung und Verwendung derartiger Pyritschichten.**

(30) Priorität: **27.07.84 DE 3428268**

(43) Veröffentlichungstag der Anmeldung:
**05.03.86 Patentblatt 86/10**

(45) Bekanntmachung des Hinweises auf die
Patenterteilung:
**23.01.91 Patentblatt 91/04**

(84) Benannte Vertragsstaaten:
**AT BE CH DE FR GB IT LI LU NL SE**

(56) Entgegenhaltungen:

**JOURNAL OF APPLIED ELECTROCHEMISTRY, Band 13, Nr. 6, November 1983, Seiten 743-750, Chapman and Hall Ltd., London, GB; W. JAEGERMANN et al.: "Photoelectrochemical reactions of FeS2 (pyrite) with H2O and reducing agents"**

**JOURNAL OF CRYSTAL GROWTH, Band 46, Nr. 1, Januar 1979, Seiten 10-14, North-Holland Publishing CO., Amsterdam, NL; S. YAMADA et al.: "Morphology of iron pryrite crystals"**

(73) Patentinhaber: **Hahn-Meitner-Institut Berlin Gesellschaft mit beschränkter Haftung Glienicker Str. 100 D-1000 Berlin 39 (DE)**

(72) Erfinder: **Tributsch, Helmut, Prof. Dr. rer. nat. Alsenstrasse 24 D-1000 Berlin 39 (DE)**
Erfinder: **Ennaoui, Ahmed, Dr. Kantstrasse 26 D-1000 Berlin 12 (DE)**
Erfinder: **Jaegermann, Wolfram, Dr. rer. nat. Ruhlaer Strasse 9 D-1000 Berlin 33 (DE)**
Erfinder: **Fiechter, Sebastian, Dr. rer. nat. Gartenstrasse 4 a D-1000 Berlin 37 (DE)**

(74) Vertreter: **Wolff, Konrad Heinrich-Hertz-Institut für Nachrichtentechnik Berlin GmbH Einsteinufer 37 D-1000 Berlin 10 (DE)**

Courier Press, Leamington Spa, England.

**Beschreibung**

Die Erfindung bezieht sich auf photoaktive Pyritschichten, Verfahren zu deren Herstellung und die Verwendung derartiger Pyritschichten.

Die bisher hauptsächlich verwendeten Halbleiter für Solarzellen sind Silizium, Cadmiumsulfid, Galliumarsenid, Kupferindiumselenid und Indiumphosphid, Halbleiter aus Silizium werden seit über drei Jahrzehnten entwickelt. Bekanntlich sind die Herstellungskosten für eine breite Kommerzialisierung jedoch noch immer zu hoch. Bei einkristallinem und polykristallinem Silizium sind die hohen Anforderungen an die Reinheit des Materials und der Energieverbrauch für die Herstellung die wichtigsten Kostenfaktoren. Bei amorphem Silizium ist eine genügende Stabilität des Materials noch nicht gewährleistet, was die Anwendung für Solarzellen bisher nur in Sonderfällen rechtfertigt.

Die übrigen Solarzellen-Materialien, die intensiv entwickelt werden, sind in der Regel noch teurer als Silizium (z.B. GaAs, InP) oder enthalten wenig häufige und toxische Elemente (z.B. Cadmium in Cadmiumsulfid).

Gegenwärtig ist noch nicht absehbar, welches Halbleitermaterial sich industriell durchsetzen wird. Der Entwicklung von Silizium wird allgemein hohe Bedeutung beigemessen. Auch die meisten Forschungsarbeiten befassen sich mit diesem Material für Solarzellen und optoelektronische Bauelemente. Für eine breite wirtschaftliche Anwendung von Silizium als Solarzellen-Material müßten sich jedoch die Herstellungskosten wenigstens auf 10% der jetzigen Kosten reduzieren lassen.

Die grundsätzliche Möglichkeit, als Solarzellen-Material Pyrit einzusetzen, ist zwar bereits aus "Journal of Applied Electrochemistry", 13 (1983) 743—750 bekannt, doch sind daraus noch nicht die für die der Erfindung zugrunde liegende Aufgabenstellung erforderlichen Detailkenntnisse zu entnehmen. Hier nun setzt die Erfindung ein, die darauf abzielt, Pyritmaterial für technische Anwendungen, insbesondere für kostengünstige Umwandlung von Solarenergie in elektrische oder chemische Energie, zu erschließen.

Photoaktive Pyritschichten, die gemäß der Erfindung die Aufgabenstellung lösen, weisen die im Patentanspruch 1 sowie gegebenenfalls auch die im Patentanspruch 2 angegebenen kennzeichnenden Merkmale auf.

Je nach gewünschtem Leitungstyp, also Eigenleitung, p- oder n-Leitung, ist für die Dotierung eines der Elemente aus der V. Haupt- oder VII. Nebengruppe für p-Typ, der VII. Haupt- oder VIII. Nebengruppe für n-Typ zu wählen. Da z.B. durch Schwefelfehlstellen das Pyrit n-Leitungscharakter aufweist, kann durch Dotierung Eigenleitungscharakter erreicht, also eine Kompensierung herbeigeführt werden.

Bezüglich Pyritmaterial und dessen Eigenschaften ist auf folgendes hinzuweisen: in der Natur sind die benötigten Ausgangsstoffe in großer Menge vorhanden; aufgrund des außerordentlich hohen Absorptionskoeffizienten, d.h. einer sehr geringen Eindringtiefe des Lichtes, reichen bereits ultradünne Pyritschichten aus, man kann sich mit einer relativ geringen Umwandlungsausbeute zufrieden geben. Überraschend ist weiterhin die hohe Quantenausbeute, die leicht erreichbar ist. Läßt sich die Photospannung auf das theoretisch erreichbare Maximum von 0,5 V (halbe Bandlücke) steigern, wächst die Umwandlungsausbeute stark, z.B. über 10%, an. Die äußerst geringe Eindringtiefe von exakt 160 Å (=0,016 µm) erlaubt schießlich, daß die Reinheitsanforderungen an das Pyritmaterial nicht so hoch sein müssen, wie beispielsweise bei Silizium; zudem ist die Flexibilität der ultradünnen Schichten und deren geringes Gewicht für die Handhabung und den Transport von erheblichem Vorteil.

Versuche mit Pyrit (FeS$_2$—Schwefelkies) haben gezeigt, daß sich bereits das in der Natur vorkommende Pyrit als Halbleitermaterial für Solarzellen und optoelektronische Bauelemente eignet. Dieses Material wird teilweise auch Eisenkies und in englischsprachiger Literatur iron pyrite, pyrite, oder volkstümlich fool's gold genannt. Die Rohstoffversorgung ist problemlos, und es kann auch auf fundierte technologische Erfahrungen der Eisenindustrie aufgebaut werden. Die Verbindung selbst, ebenso wie die Ausgangselemente, sind überdies umweltverträglich.

Es sind bisher schon über 100 unterschiedliche Verbindungen mit Pyritstruktur untersucht worden, die alle ähnliche Gitterkonstanten aufweisen und daher als Kontaktmaterialien die Herstellung von Heterojunctions, Schottkybarrieren und Multijunctions mit Pyrit (FeS$_2$) ermöglichen. Dazu gehören Verbindungen wie

$MX_2$, $MXX'$, $MXY$, $M_xM_yX_2$, $MY_2$, $MYY'$
mit M, M'=Mn, Ni, Zn, Cd, Co, Cu, Ru, Os, Rh
X, X'=S, Se, Te
Y, Y'=P, As, Sb, Bi.

Die Verbindungen sind entweder halbleitend mit einer großen Variation in den Energielücken, den Ionisierungsenergien und den Austrittsarbeiten, oder sie sind metallisch mit stark variierenden Austrittsarbeiten.

Im Vergleich zu dem bisher am meisten verwendeten Halbleitermaterial Silizium ist der Energiebedarf für die Herstellung von Pyrit wesentlich geringer. So kann FeS$_2$ aus Fe$_2$O$_3$ und/oder Fe$_3$O$_4$ sowie Schwefel hergestellt werden, wobei das technologische Knowhow der Eisenindustrie nutzbar ist. Ferner kann natürliches Pyrit durch thermische Behandlung zur Reinigung und Verbesserung bei verhältnismäßig niedrigen Temperaturen (z.B. Ionenreinigung, Tempern) verwendet werden. Schließlich entsteht Pyrit auf bisher nicht hinreichend geklärtem Wege unter natürlichen Bedingungen durch geologisch-biologische Mechanismen. Eine sich daran orientierende Synthese wäre energiemäßig außerordentlich vorteilhaft.

Pyrit und andere Übergangsmetallchalcogenide ähnlicher Elektronenstruktur (Valenz- und Leitungsband mit hohem Metall-d-Anteil) weisen gegenüber Korrosion und Photokorrosion geringe Empfindlichkeit auf; dies resultiert aus der Anregung der Elektronen-Lochpaare in quasinichtbindenden Elektronenzuständen. Das ermöglicht eine vielversprechende Anwendung in photoelektrochemischen Sonnenzellen und optoelektronischen Bauelementen.

Wesentlich für die Erfindung ist weiterhin, bevorzugte Möglichkeiten für die Herstellung von photoaktiven Pyritschichten aufzuzeigen. Wie bereits weiter oben schon erwähnt, kann dabei sowohl von natürlichem Pyrit ausgegangen werden als auch von Verbindungen, die Eisen und Schwefel enthalten. In jedem Fall schließt sich an die Behandlung des natürlichen bzw. die synthetische Erzeugung des Pyritmaterials eine Oberflächenbearbeitung der photoaktiven Schicht an. Dabei handelt es sich vor allem um Polier- und Ätzvorgänge und dergleichen.

In den betreffenden, jeweils auf Herstellungsverfahren gerichteten Patentansprüchen, sind die erfindungsgemäßen Maßnahmen angegeben. Dabei sind diese nach den verschiedenen Methoden zur Herstellung von photoempfindlichem Pyrit gegliedert:

A) aus natürlich vorkommendem Pyrit:

Es hat sich gezeigt, daß natürliche Pyritkristalle vielfach bereits geringe Photoeffekte zeigen, deren Größe stark vom Fundort abhängig ist. Relativ hohe Photoströme wurden z.B. an Pyritkristallen aus Peru (Fundort: Huanzala) festgestellt. Durch eine thermische Materialbehandlung wurde eine Verbesserung der Photoempfindlichkeit erzielt. Hierzu wurde das natürliche Pyrit in einer evakuierten Quarzampulle bei 500°C während einer Woche getempert, wodurch der Photostrom einiger Proben um den Faktor 100 erhöht wurde.

B) durch Kristallzüchtung:

Es gibt verschiedene Verfahren zur Herstellung von einkristallinem und polykristallinem Pyrit (Bromid Schmelze oder $PbCl_2$). Ein Verfahren ist die Herstellung durch Gastransportreaktionen mit Halogenen als Transportmittel. Es sind bereits Jod bzw. Chlor als Transportmittel verwendet worden. Dabei konnten polykristallines und einkristallines Pyrit mit hoher Photoempfindlichkeit in Laborversuchen mit folgenden Verfahren gewonnen werden:

B.1 Herstellung von polykristallinem Pyrit als Ausgangsmaterial:

Hierzu wurde hochreiner Schwefel (t5N5) zur Entgasung unter Hochvakuum ($10^{-5}$ bar) um Quarztiegel für 30 min erschmolzen. Nach dem Abkühlen verblieb der Schwefel unter Vakuum und wurde zur Materialentnahme unter Schutzgas gehandhabt. Hochreines Eisen in Form einer Folie t4N, Dicke=0,25 mm) oder Pulver (m5N, 60 mesh) wurde zur Reduktion der Oberfläche in einem getrockneten $H_2$/Ar-Strom (Verhältnis 1:5) für 2 Stunden auf 800°C erhitzt.

Stöchiometrische Mengen von Eisen und Schwefel (10 g) wurden in evakuierten ($10^{-5}$ bar)

und abgeschmolzenen Quarzampullen (Durchmesser 20 mm, Länge 200 mm) bei ca. 600°C (in einem früheren Versuch bei ca. 650°C) zur Reaktion gebracht. Um der thermischen Dissoziation von Pyrit in Pyrrhotin (FeS) und Schwefel vorzubeugen, wurde mit einem kleinen Schwefelüberschuß synthetisiert (650°C, Volumen der Ampulle=50 ml, Schwefelüberschuß=15 mg). In Gegenwart einer kleinen Menge eines Halogens (weniger als 1 mg/cm³, im früheren Versuch Jod (0,5 mg/cm³) wurde die Reaktion nach 100 Stunden beendet.

B.2 Präparation polykristalliner Pyritschichten aus Pyrrhotin (FeS) und Schwefel (S):

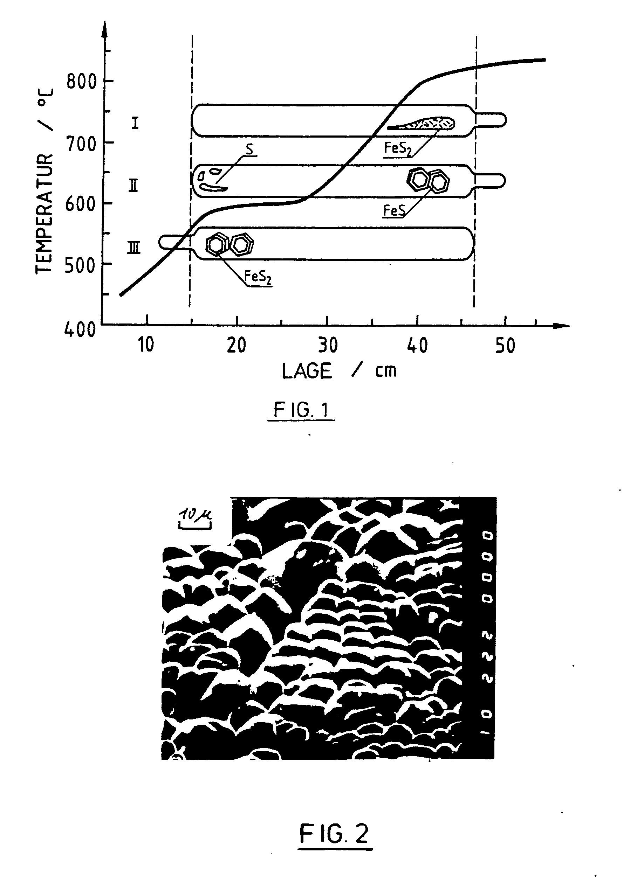

In eine Quarzampulle vom Außendurchmesser 20 mm und einer Länge von 300 mm wurden 2 g $FeS_2$ (Pyrit) in Pulverform und 5 mg As eingefüllt und auf $10^{-5}$ bar evakuiert. Nach Zugabe von Brom (0,5 mg/cm³) wurde die Ampulle abgeschmolzen. Die in einem Ampullenende plazierten Substanzen (vgl. auch Fig. 1) wurden 10 Tage in einem Widerstandsofen (Rohrofen) auf 800°C erhitzt. Das freie Ampullenende verblieb auf einer Temperatur von 550°C. Durch die Zersetzung des Pyritpulvers und durch lokalen Transport mit Brom bildeten sich Pyrrhotin-Kristalle von 10 mm Kantenlänge und 2 mm Dicke (I→II). Die magnetischen Kristalle richteten sich gemäß den magnetischen Feldlinien des Widerstandsofens aus (I=6 A, U=220 V, Durchmesser der Heizwicklung: 50 mm, Steigung der Wicklung: 2 mm, Anzahl der Windungen: 30).

Nach Umkehr des Temperaturgradienten für weitere 10 Tage bildeten sich die Pyrrhotinkristalle unter Erhaltung ihrer äußeren Form in statistisch orientierte Pyritkristalle (5—20 µm) zurück (III). Dadurch entstanden polykristalline Pyritschichten von 1 cm² Fläche, die photoaktive Eigenschaften haben. (Die Fig. 1 zeigt die Anordnung der Ampullen im Temperaturgradienten des Ofens. Die Fig. 2 zeigt rasterelektronenmikroskopische Aufnahmen dieser polykristallinen Schichten.)

B.3 Herstellung von Einkristallen durch chemischen Transport über die Gasphase mit $JCl_3$:

In einer Quarzglasampulle wurde 2 g $FeS_2$ (Pyrit) in Pulverform auf $10^{-5}$ bar evakuiert (Außendurchmesser der Quarzglasampulle: 22 mm, Länge: 125 mm). Nach Zugabe von $JCl_3$ (0,5 mg/cm³) wurde die Ampulle zugeschmolzen und $FeS_2$ im Rohrofen von 630°C nach 550°C, in einem früheren Versuch von 650°C nach 600°C transportiert. Nach 10 Tagen bildeten sich polyedrische Pyritkristalle ((100)- und (111)-Flächen) von ≦5 mm Kantenlänge. Die Kristalle sind photoaktiv.

B.4 Herstellung von Einkristallen durch chemischen Transport über die Gasphase mit $Br_2$:

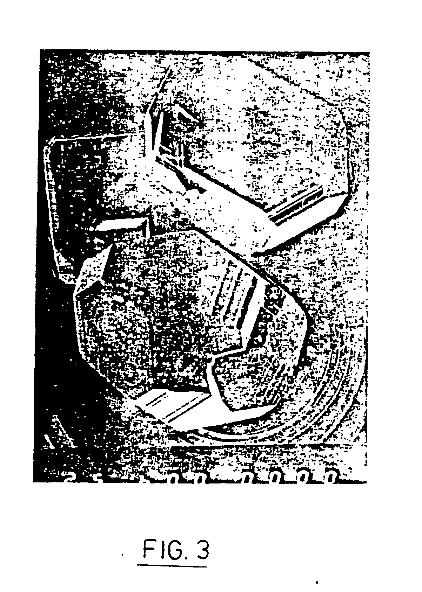

In einer Quarzglasampulle (Außendurchmesser: 22 mm, Länge: 340 mm) wurden 2 g $FeS_2$ (Pyrit) in Pulverform und 1 mg As auf $10^{-5}$ bar evakuiert und 0,5 mg/cm³ Brom zugegeben. Nach dem Abschmelzen wurde im Rohrofen von 650°C nach 600°C transportiert. Nach 11 Tagen hatten sich Kristalle ((100)- und (111)-Flächen) von $\leq 1$ mm Kantenlänge gebildet. Die photoaktiven Eigenschaften dieser Kristalle sind besser als bei den Ausführungsbeispielen zur Herstellung von polykristallinen Pyritschichten. (Die Fig. 3 zeigt eine rasterelektronenmikroskopische Aufnahme von derart hergestellten synthetischen photoaktiven $FeS_2$-Einkristallen.)

B.5 Dünnschichttechniken:

Es besteht auch die Möglichkeit, Pyrit in dünnen Schichten für Dünnschichtsolarzellen herzustellen. Die Voraussetzung für diese Anwendung ist ein hohes Absorptionsvermögen von Pyrit für Licht im sichtbaren Wellenlängenbereich. Die Untersuchungen haben gezeigt, daß Pyrit einen für sichtbares Licht hohen Absorptionskoeffizienten von mehr als $2 \times 10^4$ cm$^{-1}$ besitzt. Es wurden bereits $6,5 \times 10^5$ cm$^{-1}$ gemessen. Eine energieumwandelnde Pyritschicht muß daher nicht dicker als 1 μ oder wenige μ und kann, wie weiter oben bereits erwähnt, bis zu 0,016 μ dünn sein und mit technologisch gebräuchlichen Dünnschichtverfahren hergestellt werden. Zu diesen Verfahren, die sich bereits bewährt haben, zählen:

1. Epitaxie.
2. Sputtertechniken.
3. Elektrochemisches Abscheiden.
4. Chemischer Dampfphasentransport, insbesondere "CVD" (Chemical Vapor Deposition).
5. Plasmadeposition.

Interessante und besonders bevorzugte Ausgangsverbindungen für die Epitaxie, für CVD-Techniken und die Plasmadeposition sind beispielsweise Eisenhalogenide und Schwefelwasserstoffverbindungen oder organische Eisenverbindungen, z.B. Carbonyle wie Pentacarbonyleisen-Fe(CO)$_5$) oder Nonacarbonyl-di-eisen-Fe$_2$(CO)$_9$- und Schwefel. Außer den hier genannten bevorzugten Verbindungen kommen andere Eisen-Halogen- und eisenorganische Verbindungen in Betracht.

In den oben stehenden Erläuterungen wurde bereits auf einige Figuren hingewiesen. Die nachfolgende Figurenbeschreibung bezieht sich auf bevorzugte Ausführungsformen der Erfindung. Es zeigen:

Fig. 1: eine schematische Darstellung eines Herstellungsprozesses für polykristallines, photoaktives Pyrit,

Fig. 2: eine rasterelektronenmikroskopische Aufnahme einer polykristallinen, photoaktiven $FeS_2$-Schicht,

Fig. 3 bis 7: mehrere rasterelektronenmikroskopische Aufnahmen von synthetischen photoaktiven $FeS_2$-Einkristallen,

Fig. 8: das Schema einer photoelektrochemischen Solarzelle mit Pyrit,

Fig. 9: ein Schaubild für die Leistungscharakteristik einer photoelektrochemischen $FeS_2$-Sonnenzelle,

Fig. 10: ein Schaubild der Photostrom-Spannungskurve einer photoelektrochemischen $FeS_2$-Solarzelle bei periodischer Beleuchtung,

Fig. 11 bis 13: Schaubilder für die relative spektrale Empfindlichkeit bzw. Absorptionsspektren von $FeS_2$,

Fig. 14 und 15: Schaubilder für die Leistungscharakteristik von elektrochemischen Solarzellen mit polykristallinem $FeS_2$,

Fig. 16: eine perspektivische Darstellung für Aufbaumöglichkeiten von Festkörpersolarzellen auf Pyritbasis,

Fig. 17: ein Schaubild für die Leistungscharakteristik einer photovoltaischen Solarzelle (Schottky-Barriere), und

Fig. 18: drei Schaubilder für die zeitabhängige Photoleitfähigkeit nach einem 15 ns Laserpuls (Mikrowellenmessung) bei

a) natürlichem Pyrit, getempert bei 300°C,
b) synthetischen Pyrit, und
c) natürlichem Pyrit, getempert bei 400°C.

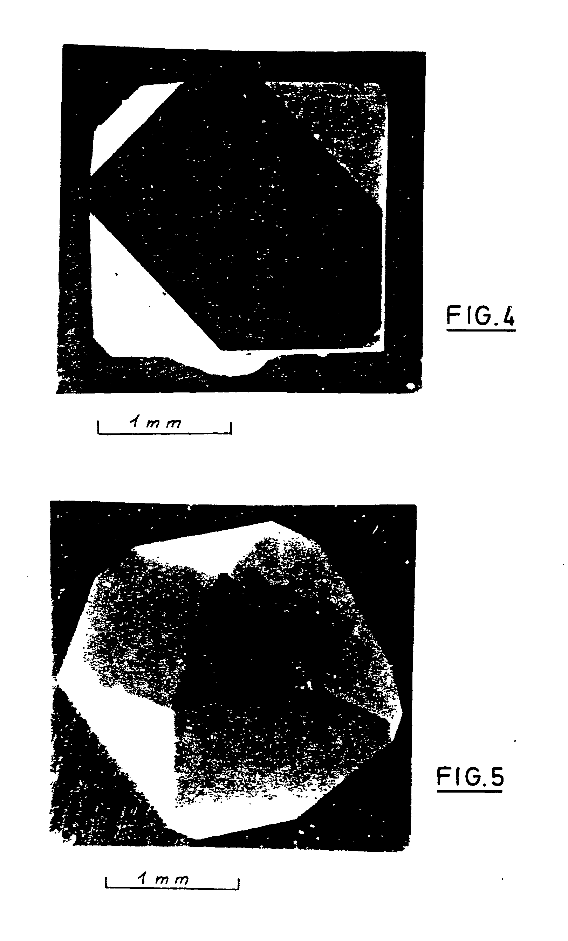

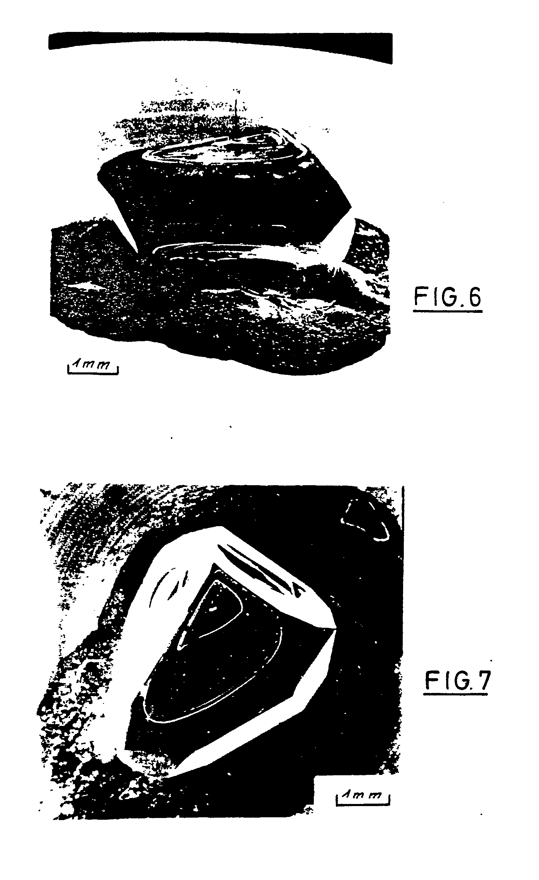

Die in Fig. 4 bis 7 gezeigten $FeS_2$-Einkristalle wurden ähnlich wie oben unter B. 4 beschrieben hergestellt, allerdings mit einem Zusatz von 1 mg Mn anstelle von As. Die Züchtungstemperatur lag bei 580°C. Diese Kristalle zeigten Kantenlängen bis zu 6 mm. Aus Rocking-Kurven wurde eine Halbwertsbreite von 4 Winkelsekunden für die Kristalle in Fig. 4 und 5 gemessen. Dies bedeutet eine hohe Perfektion der Kristallinität.

Photoelektrochemische Solarzelle

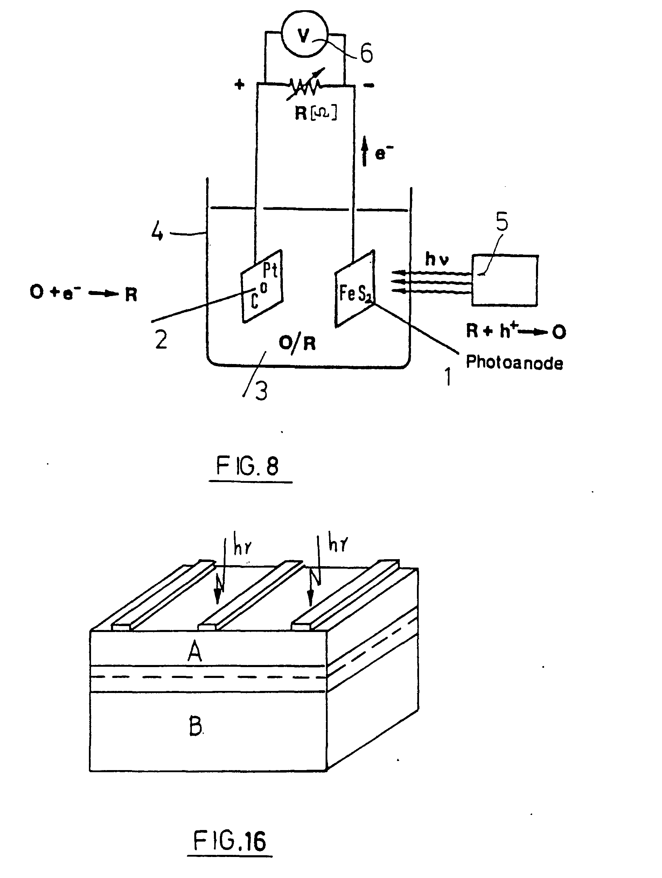

Bei der in Fig. 8 dargestellten Anordnung wird Pyrit als photoempfindliche Elektrode in einer elektrochemischen Solarzelle verwendet. Die photoaktive Elektrode 1 besteht aus einer elektrisch kontaktierten Pyritschicht. Ein Metallgitter oder ein Kohlenstoffstab dient als Gegenelektrode 2. Beide Elektroden stehen über einen wäßrigen oder organischen Elektrolyten 3, der als Zusatz ein Redox-System O/R, wie z.B. J$^-$/J$_2$, enthält, innerhalb eines Behälters 4 miteinander in Kontakt. Bei eingeschalteter Lichtquelle 5 wandelt das System das Licht in elektrische Energie —meßbar am Voltmeter 6—um. Die dabei stattfindenden Oxidations- und Reduktionsvorgänge an den beiden Elektroden sind schematisch angegeben.

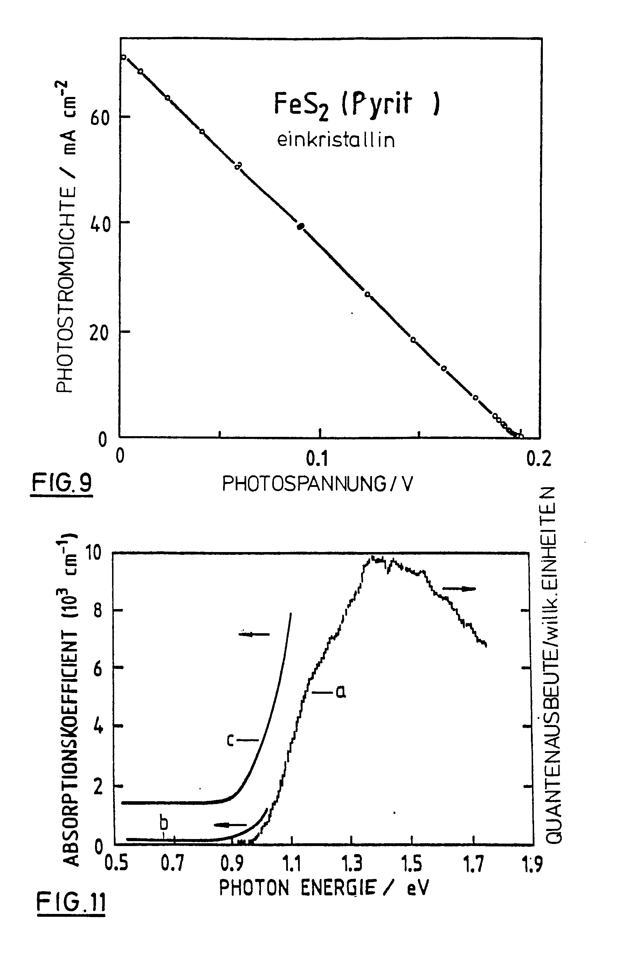

Die Leistungskurve einer solchen photoelektrochemischen $FeS_2$-Solarzelle mit einkristallinem $FeS_2$ und wäßrigem Elektrolyten (pH 3,5) mit J$^-$/J$_2$ (3 M KJ, $10^{-2}$ MJ$_2$) ist in Fig. 9 dargestellt.

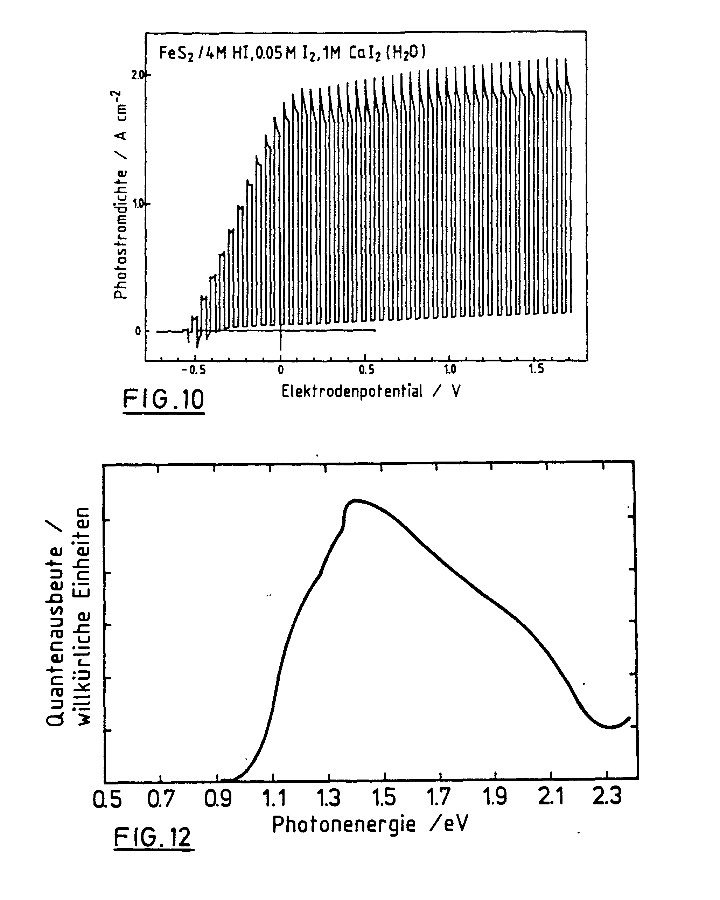

Bei der in Fig. 10 gezeigten Photostrom-Spannungskurve wurde eine wäßrige Elektrolytlösung 4 M HJ, 0,05 M J$_2$, 1 M CaJ$_2$ eingesetzt. Die Beleuchtung erfolgte mit einer Leistung von 4,5 W. Die periodische Beleuchtung verdeutlicht den Einfluß des Lichtes auf die Unterschiede zwischen Hell- und Dunkelstrom sowie auf das Abklingen des Photostromes infolge einer Verarmung der reduzierten Spezies—J$^-$—an der Oberfläche der $FeS_2$-Elektrode.

Die spektrale Abhängigkeit der Lichtempfindlichkeit zeigt Fig. 11 (Kurve a: Photostromspektrum von polykristallinem $FeS_2$ (wäßriger Elektrolyt 3 M KJ, 0,05 M J$_2$); b, c: Absorptionskoeffizient).

Fig. 12 zeigt die relative spektrale Empfindlichkeit in einem erweiterten Energiebereich unter Kurzschlußbedingungen. Die Quantenausbeute um hochenergetischen Teil des Empfindlichkeitsspektrums ist abhängig von der Oberflächenbehandlung des Pyrits.

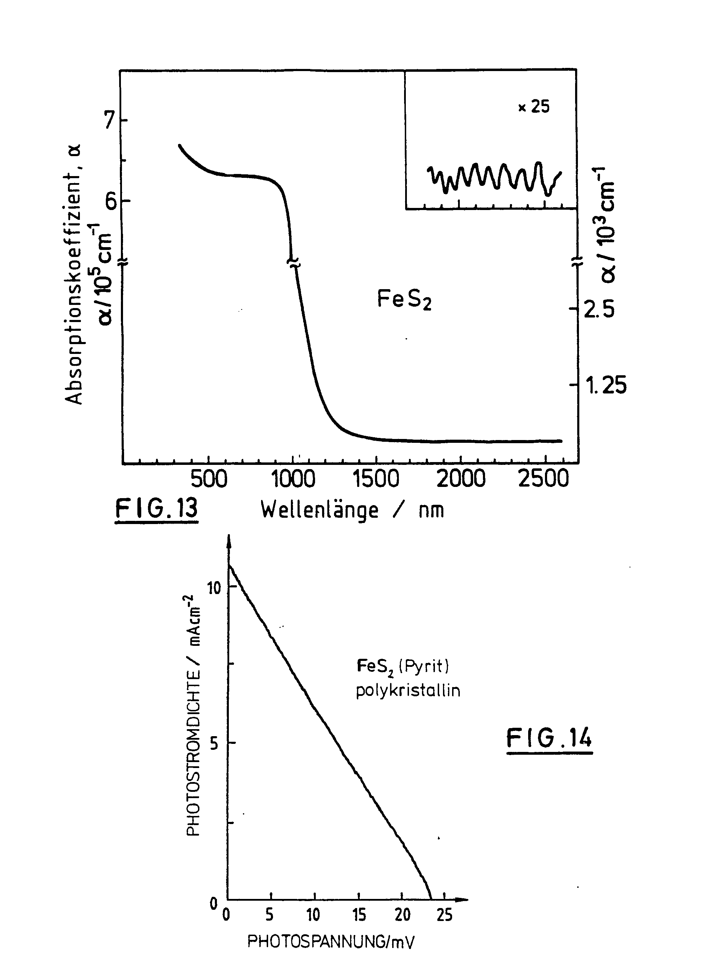

Ein vollständiges Absorptionsspektrum von Pyrit, gemessen an einer Kristallplatte von 8 µm Dicke und 50 mm² Fläche ist in Fig. 13 dargestellt.

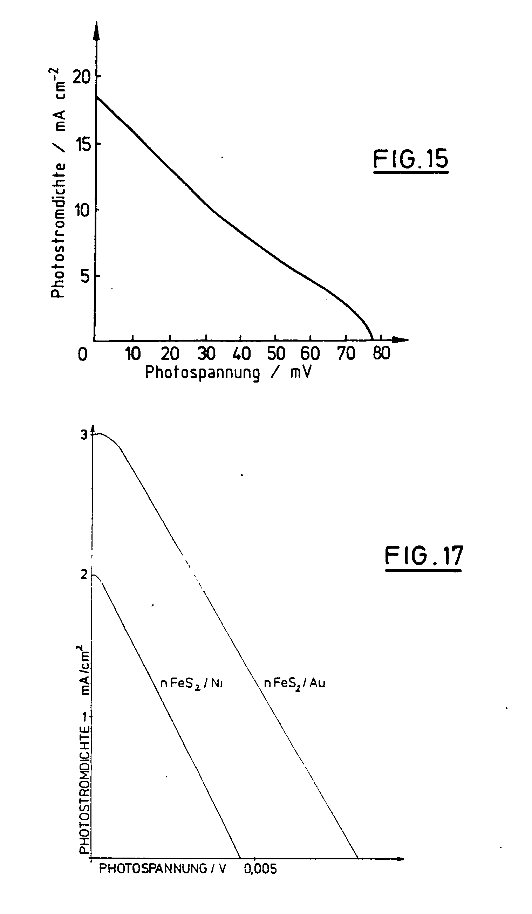

Die Leistungscharakteristik einer ersten elektrochemischen Solarzelle mit polykristallinem $FeS_2$ (wäßriger Elektrolyt, 3 M KJ, 0,05 M $J_2$) zeigt Fig. 14, Fig. 15 einer durch Oberflächenbehandlung erheblich verbesserten Version.

Durch Vorbehandlung der Oberflächen, d.h. Ätzverfahren, Tauchverfahren und dgl., können die Elektrodenoberfläche verändert und die Umwandlungsausbeute erhöht werden. Die photoelektrochemischen Eigenschaften von Pyrit lassen sich z.B. durch Eintauchen des Materials in HF (z.B. 40%, 40 s) verbessern. Als besonders effektiv hat sich herausgestellt: nach einem Polieren der Oberfläche eine Behandlung in einer konzentrierten Lösung $HF/CH_3COOH/HNO_3$ im Volumenverhältnis 1:1:2 für 60 sec, gefolgt von einer Spülung mit deionisiertem $H_2O$ und anschließendem Eintauchen in eine konzentrierte Lösung von $H_2O_2/H_2SO_4$ im Volumenverhältnis 1:1 für weitere 60 sec, dies unter elektrischer- —anodischer—Polarisierung.

Eine Variation des Elektrolyten gehört ebenfalls zu den Optimierungsmöglichkeiten, welche zur Erhöhung der Energieumwandlungsausbeute führen können. Auch kann eine Verbesserung durch Beschichtung der $FeS_2$-Oberfläche mit anderen, ebenfalls in derselben Struktur kristallisierenden Verbindungen erfolgen. Dabei ist eine Nutzung ebenfalls zur Photoelektrolyse denkbar (z.B. $RuS_2$ aufgeschichtet auf $FeS_2$).

Festkörpersolarzelle

Es gibt verschiedene Nutzungsmöglichkeiten von Pyrit als Halbleitermaterial in Festkörpersolarzellen. Die Fig. 16 zeigt schematisch den Aufbau von Festkörpersolarzellen auf Pyritbasis. So ist z.B. im Falle einer n-p Homojunction: A=n-$FeS_2$ und B=p-$FeS_2$; im Falle einer Schottky-Solarzelle: A=M; B=$FeS_2$; bei einer Heterojunction: A=$MX_2$, B=$FeS_2$.

An einer $FeS_2$/Ni- und an einer $FeS_2$/Au-Schottky-Barriere ließ sich bereits im Labormaßstab die Umwandlung von Lichtenergie nachweisen.

Dabei wurden durch die Präparation polykristalliner Pyritschichten aus Pyrrhotin hergestellte $FeS_2$-Kristalle ohne Vorbehandlung mit Ni bzw. Au (500 Å) bedampft und vermessen. Das System arbeitetet als photovoltaische Solarzelle. Die Leistungscharakteristik ist in Fig. 17 dargestellt. Die dabei noch bescheidene Photoausbeute ist u.a. auf den großen Anteil von Verunreinigungen an der $FeS_2$-Oberfläche zurückzuführen (mit XPS konnte nachgewiesen werden: FeO, $Fe_2O_3$, $SO_x$-Spezies, C-Verbindungen). Erhebliche Verbesserung der Ausbeuten, die durch Behandlung der Oberflächen sowie durch Identifizierung besser geeigneter Kontaktmaterialien (z.B. metallisch leitender $MX_2$-Verbindungen mit Pyritstruktur) erwartet wurden, konnten teilweise bereits herbeigeführt werden.

p-n Übergänge

Als Solarzellenmaterial hat Pyrit den Vorteil, daß es sowohl als n- als auch p-leitendes Material hergestellt werden kann, wobei die n-Leitung z.B. durch Dotierung mit Co oder Ni und die p-Leitung durch Dotierung mit As erzielt werden können. Durch Eindiffusion geeigneter Dotierungsstoffe in n- bzw. p-leitendes $FeS_2$ können deswegen auf einfache Weise p-n Übergänge hergestellt werden.

Als Ausführungsbeispiel wurde ein $FeS_2$-Kristall mit n-Leitfähigkeit mit einer 500 Å dicken Cu-Schicht bedampft. Anschließend wurde Cu bei 200°C 24 Stunden lang eindiffundiert. Es entstand eine n-p Homojunction. Nach Kontaktierung des n- und p-Bereiches (Cu dotiert) wurde bei Belichtung einer Photospannung von 40 mV gemessen. Durch definierte Dotierung kann diese Photospannung noch verbessert werden.

Heterojunctions

Die große Zahl der zur Verfügung stehenden Verbindungen mit Pyritstruktur ($MX_2$, $MXX'$, MXY, $M_xM_yX_2$, $MY_2$, $MYY'$) gestattet die Entwicklung von verschiedenen Heterojunctions. Als einfache präparative Herstellungsmethoden können chemische Tauchverfahren (Metallionenaustausch), elektrochemische Abscheidung, Aufwachsen aus der Gasphase und dgl. verwendet werden.

Multijunctions

Durch ähnliche Darstellungsmethoden können auch Multijunctions hergestellt werden. Auch hierbei erleichtert die große Zahl bekannter Verbindungen mit Pyritstruktur ($MX_2$, $MXX'$, MXY, $M_xM_yX_2$, $MY_2$, $MYY'$) die Wahl anpassungsfähiger Materialien. Die theoretischen Anforderungen in Bezug auf die Energiebandlagen und die Energielücken sind grundsätzlich bekannt. Auf diese Weise ist es möglich, höhere Ausbeuten zu erzielen als mit einer einzelnen photoaktiven $FeS_2$-Grenzfläche.

Anwendung von $FeS_2$ in optoelektronischen Bauelementen

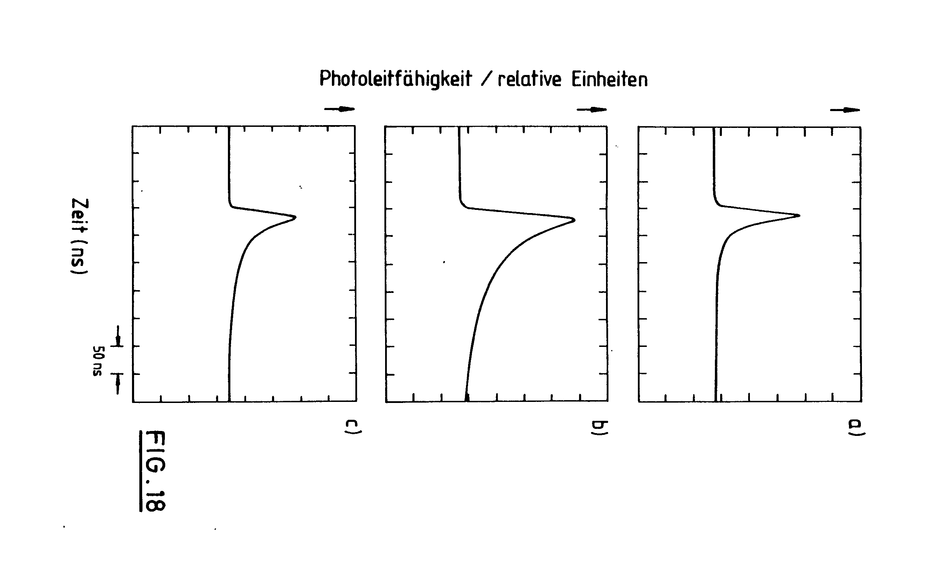

Die festgestellte hohe Lichtempfindlichkeit von entsprechend behandeltem Pyrit ermöglicht seine Anwendung in Detektoren und optoelektronischen Systemen zur Informationsübertragung. Die Lebensdauer der lichtinduzierten Ladungsträger, die für das Zeitverhalten von Pyrit als Detektor bestimmend ist, hängt von der Art der Präparation bzw. der Behandlung des Materials ab. Drei Beispiele von als lichtinduzierte Mikrowellenabsorption als Antwort auf einen 15 ns Laserpuls gemessenen Signalen sind in Fig. 18 dargestellt, nämlich a) natürliches Pyrit, bei 300°C getempert; b) synthetischer Pyrit und c) natürliches Pyrit, bei 400°C getempert. Die Flanken des Signals sind bei a) so steil, d.h. die Halbwertsbreite des elektrischen Signals ist mit ca. 25 ns so schmal, daß Bitraten von etwa 40 Mbit/s damit ohne weiteres verarbeitet werden können.

Über die der Erfindung zugrundeliegenden Arbeiten wird auch in Veröffentlichungen der wissenschaftlich-technischen Fachliteratur, insbesondere im Juli-Heft 1985 des Journal of Electrochemical Soc. von Ennaoui et al: "Photoactiv synthetic polycrystalline Pyrite (FeS₂)" und voraussichtlich in einem wenig später erscheinenden Heft derselben Zeitschrift von Ennaoui et al: "Photoelectrochemistry of highly Quantum efficient single crystalline n-FeS₂ (Pyrite)" berichtet.

**Patentansprüche**

1. Photoaktive Pyritschicht, gekennzeichnet durch
—eine Stöchiometrieabweichung des Pyritmaterials entsprechend der Formel $FeS_{2\pm x}$ mit $x \leq 0,05$,
—eine Konzentration an unerwünschten Verunreinigungen von $<10^{20}$ pro cm³,
—eine Dotierung mit Mangan (Mn) oder Arsen (As) bzw. Kobalt (Co) oder Chlor (Cl) von etwa $10^{16}$ bis $10^{19}$ pro cm³.

2. Photoaktive Pyritschicht für Solarzellen, insbesondere nach Anspruch 1, gekennzeichnet durch
—eine Umwandlungsausbeute von wenigstens 1%,
—eine Quantenausbeute von bis zu etwa 90%,
—eine Photospannung von mehr als 0,25 V,
—eine effektive Ladungsträgerdichte von mehr als $10^{15}$ pro cm³ und
—eine abgeleitete Ladungsträger-Beweglichkeit um 200 cm²/Vs.

3. Verfahren zur Herstellung von photoaktiven Pyritschichten nach Anspruch 1 oder 2, dadurch gekennzeichnet, daß
—natürliches Pyrit einer thermochemischen Behandlung derart unterzogen wird, daß die gewünschte Kristallinität, Reinheit und Stöchiometrie des Materials erreicht und
—aus dem wärmebehandelten Pyrit erzeugte Schichten mittels einer Oberflächenbehandlung hinsichtlich der Photoempfindlichkeit weiter verbessert werden.

4. Verfahren nach Anspruch 3, dadurch gekennzeichnet, daß das Pyrit in Form von Blöcken thermisch behandelt wird und Schichten als Scheiben von den Blöcken abgetrennt werden.

5. Verfahren nach Anspruch 3, dadurch gekennzeichnet, daß das Pyrit in Pulverform thermisch behandelt wird und Schichten durch chemischen Transport erzeugt werden.

6. Verfahren nach einem der Ansprüche 3 bis 5, dadurch gekennzeichnet, daß die thermische Behandlung in einem evakuierten Behälter bei etwa 500°C über einen Zeitraum von etwa 1 Woche durchgeführt wird.

7. Verfahren zur Hestellung von photoaktiven Pyritschichten nach Anspruch 1 oder 2, dadurch gekennzeichnet, daß

—das Pyritmaterial synthetisch durch Reaktion zwischen eisen bzw. Eisenhaltigen Verbindungen und Schwefel bzw. schwefelhaltigen Verbindungen erzeugt und
—durch Kristallzucht entweder dünne Schichten oder Kristallkörper, von denen Scheiben abzutrennen sind, gebildet und
—die so erzeugten Materialschichten mittels einer Oberflächenbehandlung hinsichtlich der Photoempfindlichkeit weiter verbessert werden.

8. Verfahren nach Anspruch 7, dadurch gekennzeichnet, daß einerseits:
—hochreiner Schwefel unter Hochvakuum in etwa 30 Minuten erschmolzen wird,
—die Schwefelschmelze abgekühlt und unter Vakuum gehalten sowie zur Materialentnahme unter Schutzgas gehandhabt wird, andererseits:
—hochreines Eisen in Pulver- oder Folienform, zur Reduktion der Oberfläche unter einem Strom von getrocknetem $H_2$/Ar-Gasgemisch, für etwa 2 Stunden auf etwa 800°C erhitzt wird, und sodann:
—stöchiometrische Mengen von Eisen und Schwefel in einem evakuierten, abgeschlossenen Behälter bei ca. 650°C, insbesondere 600°C, zur Reaktion gebracht werden und diese Reaktion unter Zugabe einer kleinen Menge, beispielsweise 1 mg/cm³, eines Halogens, beispielsweise Jod, und zur Vorbeugung gegen thermische Dissoziation von Pyrit in Pyrrhotin und Schwefel mit geringem Überschub an Schwefel, nach etwa 100 Stunden beendet wird.

9. Verfahren nach Anspruch 7, dadurch gekennzeichnet, daß
—Pyritpulver und Arsen in einem auf Hochvakuum gebrachten und nach Zugabe von Brom abgeschlossenen Behälter an einer Stelle plaziert werden,
—der Behälter an der Stelle, wo das Pyritpulver und Arsen plaziert sind, auf ca. 800°C erwärmt und an einer anderen Stelle auf ca. 550°C gehalten wird, so daß sich über einen Zeitraum von etwa 10 Tagen durch Zersetzung des Pyritpulvers und durch lokalen Transport mit Brom Pyrrhotinkristalle in dunner Schicht ausbilden, und
—für weitere 10 Tage unter Umkehr des Temperaturgradienten die dünne Schicht der Pyrrhotinkristalle unter Erhaltung ihrer äußeren Form in statistisch orientierte Pyritkristalle zurückgebildet werden.

10. Verfahren nach Anspruch 7, dadurch gekennzeichnet, daß die Kristallzucht des Pyrits durch Gastramnsportreaktionen mit einem Halogen, insbesondere Jod, Brom, Chlor oder Jodtrichlorid (JCl₃), als Transportmittel durchgeführt wird.

11. Verfahren nach Anspruch 7, dadurch gekennzeichnet, daß Pyrit als dünne Schicht auf einem amorphen oder kristallinen Substrat aus der Gasphase durch thermische Zersetzung und Reaktion von Eisen-Carbonylen, insbesondere $Fe(CO)_5$, $Fe_2(CO)_9$, mit Schwefel oder Schwefelwasserstoffgas oder von Eisen-Halogeniden, insbesondere $Fe(X)_2$ mit X=Cl, Br, J, abgeschieden wird.

12. Verfahren nach einem der Ansprüche 3 bis 11, dadurch gekennzeichnet, daß die Oberfläche der photoaktiven Pyritschicht zunächst poliert und naßchemisch in zwei Stufen geätzt wird, nämlich:

—für ca. 30 sec bis 60 sec mit einer konzentrierten Lösung: HF/CH₃COOH/HNO₃, Mischungsverhältnis 1:1:2, und sodann

—mit H₂O₂, 30%ig/H₂SO₄, 96%ig, Mischungsverhältnis 1:1.

13. Verwendung einer photoaktiven Pyritschicht nach Anspruch 1 oder 2 oder hergestellt nach einem der Ansprüche 3 bis 11 als Solarzellenelektrode.

14. Verwendung einer photoaktiven Pyritschicht nach Anspruch 1 oder 2 oder hergestellt nach einem der Ansprüche 3 bis 11, als optoelektronisches Bauelement.

15. Verwendung einer photoaktiven Pyritschicht, hergestellt nach Anspruch 12, als Elektrode in einer photoelektrochemischen Solarzelle mit einer wäßrigen Lösung von 4 M HJ, 0,05 M J₂, 1 M Ca J₂ als Elektrolyt.

**Revendications**

1. Couche de pyrite photoactive, caractérisée par:

—une déviation stoéchiométrique du matériau de la pyrite conformément à la formule $FeS_{2+x}$, avec $x \leqq 0,05$,

—une concentration d'impuretés indésirables inférieure à $10^{20}$ par cm³,

—un dopage au manganèse (Mn), à l'arsenic (As), au cobalt (Co) ou au chlore (Cl) entre environ $10^{16}$ et $10^{19}$ par cm³.

2. Couche de pyrite photoactive pour cellules solaires, notamment selon la revendication 1, caractérisée par:

—un rendement de conversion d'au moins 1%,

—un rendement quantique pouvant atteindre 90%,

—une tension photoélectrique supérieure à 0,25 V,

—une épaisseur de support de charge effective supérieure à $10^{15}$ par cm³, et

—une mobilité de support de charge dérivée de 200 cm²/Vs.

3. Procédé de préparation des couches de pyrite photoactives selon la revendication 1 ou 2, caractérisé en ce que:

—on soumet de la pyrite naturelle à un traitement thermochimique permettant d'atteindre la cristallinité, la pureté et la stoéchiométrie désirées du matériau, et

—les couches obtenues au moyen de la pyrite traitée thermiquement sont encore améliorées en ce qui concerne leur sensibilité photoélectrique par un traitement de surface.

4. Procédé selon la revendication 3, caractérisé en ec que la pyrite est traitée thermiquement sous forme de blocs et les couches sont séparées des blocs sous forme de tranches.

5. Procédé selon la revendication 3, caractérisé en ce que la pyrite est traitée thermiquement sous forme d'une pourdre et les couches sont obtenues par transport chimique.

6. Procédé selon l'une quelconque des revendications 3 à 5, caractérisé en ce que le traitement thermique est réalisé dans un récipient sous vide à environ 500°C pendant une durée d'environ une semaine.

7. Procédé de préparation de couches de pyrite photoactives selon la revendication 1 ou 2, caractérisé en ce que:

—la pyrite est préparée synthétiquement par réaction entre du fer ou des composés contenant du fer et du soufre ou des composés contenant du soufre, et

—des couches minces ou des corps cristallins dont sont séparées les tranches sont formées par culture cristalline, et

—les couches de matériau ainsi obtenues sont encore améliorées par un traitement de surface concernant la sensibilité à la lumière.

8. Procédé selon la revendication 7, caractérisé en ce que d'une part:

—on fait fondre du soufre de grande pureté sous un vide élevé pendant environ 30 minutes,

—on refroidit la masse de soufre et on la maintient sous vide, et on la traite sous un gaz protecteur pour prélever le matériau, et d'autre part:

—on chauffe pendant environ 2 heures à environ 800°C du fer de grande pureté sous forme de poudre ou de feuille, pour la réduction de la surface sous un courant d'un mélange de gaz secs H₂/Ar, et ainsi:

—on fait réagir des quantités stoéchiométriques de fer et de soufre dans un récipient sous vide et fermé à environ 650°C, et notamment à 600°C, et on met fin à cette réaction après environ 100 heures après addition d'une faible quantité de par exemple 1 mg/cm³ d'un halogène tel que de l'iode, et avec un léger excès de soufre pour éviter une dissociation thermique de la pyrite en pyrrhotine et soufre.

9. Procédé selon la revendication 7, caractérisé en ce que

—on met de la poudre de pyrite et de l'arsenic dans un récipient sous un vide élevé et fermé après addition de brome, et on les place en un endroit, et

—on chauffe le récipient à l'endroit où la poudre de pyrite et l'arsenic ont été placés à environ 800°C et on le maintient en un autre endroit à environ 550°C de manière qu'après une durée d'environ 10 jours, après décomposition de la poudre de pyrite et par transport local avec du brome, se constituent des cristaux de pyrrhotine en couches minces, et

—on reconstitue la couche mince de cristaux de pyrrhotine en conservant leur forme extérieure sous forme de cristaux de pyrite orientés statistiquement pendant encore 10 jours et après inversion des gradients de température.

10. Procédé selon la revendication 7, caractérisé en ce que la culture de cristaux de pyrite est réalisée par des réactions de transport gazeux avec un halogène, notamment de l'iode, du chrome, du chlore ou du trichlorure d'iode (JCl₃) en tant que moyen de transport.

11. Procédé selon la revendication 7, caractérisé en ce que la pyrite est déposée sous forme d'une couche mince sur un substrat amorphe ou cristallin à partir de la phase gazeuse par décomposition thermique et réaction de carbonyles de fer, notamment $Fe(CO)_5$, $Fe_2(CO)_9$, avec du soufre ou du gaz d'acide sulfurique ou à partir d'halogénures de fer, notamment $Fe(X)_2$ avec X=Cl, Br, J.

12. Procédé selon l'une quelconque des revendications 3 à 11, caractérisé en ce que la surface de la couche de pyrite photoactive est d'abord polie et ensuite décapée chimiquement en deux étapes, à savoir:
— pendant environ 30 à 60 secondes avec une solution concentrée de $HF/CH_3COOH/HNO_3$, selon un rapport de mélange de 1:1:2, et ensuite,
— avec un mélange de $H_2O_2$ à 30% et de $H_2SO_4$ à 96% selon un rapport de 1:1.

13. Utilisation d'une couche de pyrite photoactive selon la revendication 1 ou 2 ou réalisée selon l'une quelonque des revendications 3 à 11, en tant qu'électrode de cellule solaire.

14. Utilisation d'une couche de pyrite photoactive selon la revendication 1 ou 2 ou réalisée selon l'une quelconque des revendications 3 à 11, en tant que composant optoélectronique.

15. Utilisation d'une couche de pyrite photoactive préparée selon la revendication 12 en tant qu'électrode dans une cellule solaire photoélectrochimique comprenant une solution aqueuse de 4 M HJ, 0,05 M $J_2$, 1 M Ca $J_2$ en tant qu'électrolyte.

## Claims

1. Photo-active pyrite layer, characterised by
— a variation in the stoichiometry of the pyrite material according to the formula $FeS_{2\pm x}$ with $x \leq 0.05$,
— a concentration of undesired impurities of $<10^{20}$ per $cm^3$,
— a doping with manganese (Mn) or arsenic (As), or cobalt (Co) or chlorine (Cl), respectively, of approximately $10^{16}$ to $10^{19}$ per $cm^3$.

2. Photo-active pyrite layer for solar cells, in particular according to claim 1, characterised by
— a transformation yield of at least 1%,
— a quantum yield of up to approximately 90%,
— a photo-electric voltage of more than 0.25 V,
— an effective charge carrier density of more than $10^{15}$ per $cm^3$ and
— a derived charge carrier mobility around 200 $cm^2/Vs$.

3. Process for manufacturing photo-active pyrite layers according to claim 1 or 2, characterised in that
— natural pyrite is subjected to thermochemical treatment so that the desired crystallinity, purity and stoichiometry of the material are achieved and
— layers produced from the heat-treated pyrite are further improved in respect of their photosensitivity by means of a surface treatment.

4. Process according to claim 3, characterised in that the pyrite is heat treated in the form of blocks and layers are separated from the blocks as wafers.

5. Process according to claim 3, characterised in that the pyrite is heat treated in powder form and layers are produced by chemical transport.

6. Process according to one of claims 3 to 5, characterised in that the heat treatment is carried out in an evacuated container at approximately 500°C over a period of approximately one week.

7. Process for the manufacture of photo-active pyrite layers according to claim 1 or 2, characterised in that
— the pyrite material is synthetically produced by a reaction between iron or iron-containing compounds and sulphur or sulphur-containing compounds and
— either thin layers or crystal bodies, from which wafers are to be separated, are formed by crystal growth and
— the layers of material thus produced are further improved in respect of their photo-sensitivity by means of a surface treatment.

8. Process according to claim 7, characterised in that on the one hand:
— high-purity sulphur is melted under a high vacuum in approximately 30 minutes,
— the melted sulphur is cooled and maintained under a vacuum and handled under protective gas for the withdrawal of material, and on the other hand:
— high-purity iron in the form of powder or foil, for the reduction of the surface under a current of dried $H_2/Ar$ gas mixture, is heated for approximately 2 hours at approximately 800°C, and then:
— stoichiometric amounts of iron and sulphur are caused to react in an evacuated, sealed container at approximately 650°C, in particular 600°C, and this reaction, with the addition of a small amount, for example 1 $mg/cm^3$, of a halogen, for example iodine, and for the prevention of thermal dissociation of pyrite into pyrrhotite and sulphur with a small excess of sulphur, is ended after approximately 100 hours.

9. Process according to claim 7, characterised in that
— pyrite powder and arsenic in a container brought to a high vacuum and sealed after addition of bromine, are put in a place,
— the container, at the place where the pyrite powder and arsenic are put, is heated at approximately 800°C and maintained at another place at approximately 550°C, so that, over a period of approximately 10 days, due to decomposition of the pyrite powder and due to local transport with bromine, pyrrhotite crystals form in a thin layer, and
— for a further 10 days, with reversal of the temperature gradient, the thin layer of pyrrhotite crystals, with conservation of their outer form, are formed back into statistically oriented pyrite crystals.

10. Process according to claim 7, characterised in that the crystal growth of the pyrite is carried out by means of gas transport reactions with a halogen, in particular iodine, bromine, chlorine or iodine trichloride ($ICl_3$), as the transport means.

11. Process according to claim 7, characterised in that pyrite is deposited as a thin layer on an amorphous or crystalline substrate from the gas phase by thermal decomposition and reaction of iron carbonyls, in particular $Fe(CO)_5$, $Fe_2(CO)_9$, with sulphur or hydrogen sulphide gas, or of iron halogenides, in particular $Fe(X)_2$ with $X=Cl$, Br, I.

12. Process according to one of claims 3 to 11, characterised in that the surface of the photo-active pyrite layer is first polished and wet-chemical etched in two stages, namely:

—for approximately 30 to 60 seconds with a concentrated solution: $HF/CH_3COOH/HNO_3$, mixing proportion 1:1:2, and then

—with $H_2O_2$, 30%/$H_2SO_4$, 96%, mixing proportion 1:1.

13. Use of a photo-active pyrite layer according to claim 1 or 2 or manufactured according to one of claims 3 to 11, as a solar cell electrode.

14. Use of a photo-active pyrite layer according to claim 1 or 2 or manufactured according to one of claims 3 to 11, as an opto-electronic component.

15. Use of a photo-active pyrite layer, manufactured according to claim 12, as an electrode in a photo-electrochemical solar cell with an aqueous solution of 4 M HI, 0.05 M $I_2$, 1 M Ca $I_2$ as the electrolyte.

FIG. 1

FIG. 2

FIG. 3

FIG.4

1 mm

FIG.5

1 mm

FIG.6

1mm

FIG.7

1mm

FIG. 8

FIG.16

5

EP 0 173 642 B1

FIG.9

FIG.11

6

FeS$_2$ / 4M HI, 0.05 M I$_2$, 1M CaI$_2$ (H$_2$O)

FIG.10

Elektrodenpotential / V

FIG.12

Photonenergie /eV

EP  0 173 642  B1

FIG.13

FIG.14

FIG.15

FIG.17

9

FIG.18